# EUROPEAN PATENT APPLICATION

(11) **EP 4 844 428 A1**
(43) Date of publication of application: **25.11.2026**
(21) Application number: 25861049.2
(22) Date of filing: 01.07.2025
(51) Int. Cl.: G01R 31/396, G01R 31/392, G01R 31/367, G01R 31/385, G01R 19/165, G01R 19/10, G01R 19/12

(54) **BATTERY MANAGEMENT DEVICE AND BATTERY MANAGEMENT METHOD**

(30) Priority: 02.09.2024 KR 20240118399
(71) Applicant: LG Energy Solution, Ltd., Seoul 07335 (KR)
(72) Inventor: CHOI, Won, Daejeon 34122 (KR); SUNG, Yong Chul, Daejeon 34122 (KR)
(74) Representative: Plasseraud IP
(86) International application number: PCT/KR2025/009350
(87) International publication number: WO 2026/049251

(57) **Abstract**

A battery management method of the present disclosure comprises the steps of: obtaining a noise level on the basis of a cell voltage change amount of a selected battery cell selected from a slave including a plurality of battery cells; obtaining a deviation of the selected battery cell on the basis of a cell voltage average value change amount, which is a difference between cell voltage average values of the selected battery cell for each of a current section and a previous section, a change amount average value, which is an average value of the cell voltage average value change amounts of the plurality of battery cells, and the noise level; obtaining a final signal of the selected battery cell on the basis of the deviation; and determining whether the selected battery cell is abnormal on the basis of a first comparison result of a level of the final signal and a first threshold value.

## Description

### Technical Field

This application claims the benefit of Korean Patent Application No. 10-2024-0118399, filed on September 2, 2024, in the Korean Intellectual Property Office, the disclosure of which is incorporated herein by reference in its entirety.

The present disclosure relates to a battery management apparatus and a battery management method.

### Background Art

A battery is widely used as an energy source for various electronic devices. In order to secure safety, the technique of determining or diagnosing the status of the battery becomes increasingly important. For example, the battery may be diagnosed by using the voltage of the battery. However, when the voltage has noise, diagnosing whether a micro inflection signal is caused by the noise is difficult, and an over-detection rate may be increased.

### Detailed Description of the Invention

### Technical Goals

Example embodiments of the present disclosure are to provide a battery management apparatus and a battery management method that improve safety of a battery.

However, the goals to be achieved by example embodiments of the present disclosure are not limited to the objectives described above and other objects may be clearly understood from the following example embodiments.

### Technical solutions

According to an aspect, there is provided a battery management method including acquiring a noise level based on cell voltage variations in a selected battery cell selected in a slave including a plurality of battery cells, acquiring a deviation of the selected battery cell based on a cell voltage average value variation that is a difference between respective cell voltage average values of the selected battery cell in a current period and a previous period, a variation average value that is an average value of cell voltage average value variations of the plurality of battery cells, and the noise level, acquiring a final signal of the selected battery cell based on the deviation, and determining whether the selected battery cell is abnormal based on a first comparison result between a level of the final signal and a first threshold value.

The acquiring of the final signal may include acquiring a slope of the deviation, which is a difference between a deviation variation of the deviation and a deviation average value variation, and acquiring the final signal which corresponds to the deviation and the slope.

The acquiring of the final signal may further include acquiring a value, which is obtained by dividing the deviation by a noise reduction level, as a noise reduction value, and the acquiring of the final signal which corresponds to the deviation and the slope, may include acquiring a value obtained by multiplying the deviation, the slope, and the noise reduction value together as the final signal.

The deviation variation may be a value obtained by multiplying a difference between deviations of the selected battery cell in the current period and the previous period by a slope scale.

The deviation average value variation may be a value obtained by multiplying a difference between average values of deviations of the plurality of battery cells in the current period and the previous period by a slope scale.

The determining of whether the selected battery cell is abnormal may include acquiring a second comparison result by comparing a deviation ratio, which is based on a first maximum value and a minimum value of the deviation, and a second threshold value, and determining whether the selected battery cell is abnormal depending on the first comparison result and the second comparison result.

The acquiring of the second comparison result may include acquiring a first ratio of a second maximum value of the deviation, excluding the first maximum value, to the first maximum value, acquiring a second ratio of one of the first maximum value and the second maximum value to the minimum value, and acquiring a difference between the first ratio and the second ratio as the deviation ratio.

The acquiring of the noise level may include acquiring a first calculation value obtained by dividing a sum of squares of the cell voltage variations by a number of the cell voltage variations, acquiring a second calculation value which is a square of a value obtained by dividing a sum of the cell voltage variations by the number of the cell voltage variations, and acquiring a third calculation value, which is obtained by multiplying a root value of a difference between the first calculation value and the second calculation value by a noise scale, as the noise level.

The acquiring of the deviation may include acquiring, as a first calculation value, a difference between the cell voltage average value variation in the selected battery cell in the current period and the variation average value of the plurality of battery cells in the previous period, acquiring, as a second calculation value, a difference between the cell voltage average value variation in the selected battery cell in the current period and the variation average value of the plurality of battery cells in the current period, acquiring a value, which is obtained by dividing a sum value of the first difference value and the second difference value by the variation average value of the plurality of battery cells in the current period, as a third calculation value, and acquiring a fourth calculation value, which is obtained by dividing the third calculation value by the noise level, as the deviation.

According to another aspect, there is also provided a battery management apparatus including an information acquisition interface configured to acquire a cell voltage of each of a plurality of battery cell included in a slave, and a processor, and the processor is configured to acquire a noise level based on cell voltage variations in a selected battery cell selected in the slave, acquire a deviation of the selected battery cell based on a cell voltage average value variation that is a difference between respective cell voltage average values of the selected battery cell in a current period and a previous period, a variation average value that is an average value of cell voltage average value variations of the plurality of battery cells, and the noise level, acquire a final signal of the selected battery cell based on the deviation, and determine whether the selected battery cell is abnormal based on a first comparison result between a level of the final signal and a first threshold value.

According to another aspect, there is also provided a computer-readable recording medium in which a program for executing the battery management method on a computer is recorded.

Additional aspects of example embodiments will be set forth in part in the description which follows and, in part, will be apparent from the description, or may be learned by practice of the disclosure.

### Effects of the Invention

According to example embodiments, one or more of the following effects may be expected.

According to example embodiments of the present disclosure it is possible to provide a battery management apparatus and a battery management method that improve safety of a battery.

According to example embodiments, it is possible to provide the battery management apparatus and the battery management method which accurately diagnose a status of the battery. According to example embodiments, it is possible to improve accuracy of a diagnosis. According to example embodiments, it is possible to reduce an over-inspection rate of the diagnosis due to noise.

Effects of the present disclosure are not limited to those described above and other effects may be made apparent to those skilled in the art from the following description of the accompanying claims.

### Brief Description of Drawings

FIG. 1 is a diagram for describing a battery management apparatus according to example embodiments.
FIG. 2 is a block diagram for describing a battery management apparatus according to example embodiments.
FIG. 3 is a flowchart for describing a battery management method according to example embodiments.
FIG. 4 is a diagram for describing a noise level according to example embodiments.
FIG. 5 is a diagram for describing a cell voltage average value, a cell voltage average value variation, and a variation average value according to example embodiments.
FIG. 6 is a diagram for describing a deviation, a slope, a noise reduction value, and a final signal according to example embodiments.
FIG. 7 is a diagram for describing a method of acquiring a noise reduction value according to example embodiments.
FIG. 8 is a diagram for describing a battery management method according to example embodiments.

### Mode for Carrying Out the Invention

Terms used in the example embodiments are selected, as much as possible, from general terms that are widely used at present while taking into consideration the functions obtained in accordance with the present disclosure, but these terms may be replaced by other terms based on intentions of those skilled in the art, customs, emergence of new technologies, or the like. Also, in a particular case, terms that are arbitrarily selected by the applicant of the present disclosure may be used. In this case, the meanings of these terms may be described in corresponding description parts of the disclosure. Accordingly, it should be noted that the terms used herein should be construed based on practical meanings thereof and the whole content of this specification, rather than being simply construed based on names of the terms.

In the entire specification, when an element is referred to as "including" another element, the element should not be understood as excluding other elements so long as there is no special conflicting description, and the element may include at least one other element. In addition, the terms "unit" and "module", for example, may refer to a component that exerts at least one function or operation, and may be realized in hardware or software, or may be realized by combination of hardware and software.

In the following description, example embodiments of the present disclosure will be described in detail with reference to the accompanying drawings so that those skilled in the art can easily carry out the present disclosure. However, the present disclosure may be embodied in many different forms and is not limited to the example embodiments described herein.

Hereinafter, the example embodiments of the present disclosure will be described with reference to the accompanying drawings.

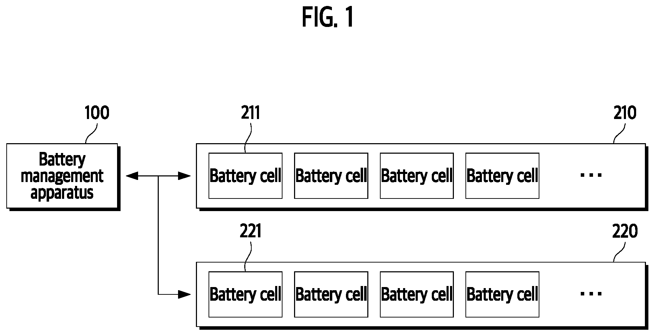

FIG. 1 is a diagram for describing a battery management apparatus according to example embodiments.

Referring to FIG. 1, a battery management apparatus 100 according to example embodiments of the present disclosure may manage at least one battery. The battery may supply electrical energy to various types of electronic apparatuses. For example, an electronic apparatus may be a vehicle, a drone, a data center, a telecommunication base station, mercantile equipment, industrial equipment, a mobile device, or the like. The battery may refer to a battery cell 211 or 221.

The battery cell 211 or 221 may store or emit energy through an electrochemical reaction. The battery cell 211 or 221 may be secondary batteries of which charging and discharging is repeatable. The battery cells 211 or 221 may include a positive electrode, a negative electrode, an electrolyte, and an exterior material. For example, the positive electrode may include at least one of materials such as lithium cobalt oxide, lithium iron phosphate, and nickel manganese cobalt oxide. The negative electrode may include at least one of materials such as graphite and silicon. The electrolyte may be a medium through which a lithium ion moves and include at least one of an organic solvent and a lithium salt compound. The exterior material may protect another element of the battery cell 211 or 221 from an external environment. For example, the exterior environment may be an aluminum-polymer composite film in a flexible form or a rectangular or cylindrical case. In example embodiments, the battery cell 211 or 221 may further include a separator that prevents the positive electrode and the negative electrode from being in contact with each other. In example embodiments, the battery cell 211 or 221 may be various types of secondary batteries such as a lithium-ion battery, a lithium-ion polymer battery, a nickel-cadmium battery, a nickel-metal hydride battery, and a solid-state battery. Multiple battery cells 211 or 221 may be packaged in one unit such as a battery module or a battery pack. Meanwhile, the battery cell 211 or 221 may be simply referred to as a cell.

The battery management apparatus 100 according to example embodiments of the present disclosure may manage at least one slave 210 or 220. As an example, the battery management apparatus 100 may be a battery management system mounted to a vehicle. As another example, the battery management apparatus 100 may be a server. However, it is merely an example embodiment, and the battery management apparatus 100 may be carried out as various types of electronic apparatuses.

The slave 210 or 220 may include a plurality of battery cells 211 or 221. The plurality of battery cells 211 or 221 in an identical slave 210 or 220 may be connected in series, in parallel, or according to a combination thereof. The number of battery cells 211 included in one slave 210 may be equal to or different from the number of battery cells 221 included in another slave 220. In example embodiments, the slave 210 or 220 may be a group of units in which the battery cell 211 or 221 is monitored or controlled. In example embodiments, the battery module may include the at least one slave 210 or 220. Hereinafter, a description will be provided with the one slave 210 as a reference. A description of the one slave 210 may be identically applied to the other slave 220.

In example embodiments, the battery management apparatus 100 may diagnose whether each of the plurality of battery cells 211 is abnormal by using a cell voltage of each of the plurality of battery cells 211 included in the slave 210. According to the present disclosure, even when noise is in the cell voltage, accuracy of diagnosis may be improved, and an over-detection rate in the diagnosis may be reduced. Descriptions associated therewith will be provided in detail with reference to the accompanying drawings.

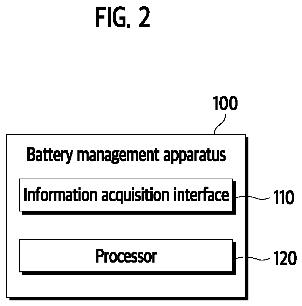

FIG. 2 is a block diagram for describing a battery management apparatus according to example embodiments.

Referring to FIG. 2, the battery management apparatus 100 according to example embodiments may include an information acquisition interface 110 and a processor 120.

The information acquisition interface 110 may acquire a cell voltage of the battery cell 211. In example embodiments, the information acquisition interface 110 may acquire the cell voltage of the battery cell 211 periodically over time. The information acquisition interface 110 may transfer the cell voltage of the battery cell 211 to the processor 120.

In an example embodiment, the information acquisition interface 110 may include a voltage sensor that acquires the cell voltage by measuring a potential difference between a positive electrode and a negative electrode. In this case, the information acquisition interface 110 may acquire the cell voltage of the battery cell 211 by directly measuring the cell voltage.

In another example embodiment, the information acquisition interface 110 may include a communication circuit that performs communication through a wired communication channel or a wireless communication channel. The communication circuit may receive the cell voltage of the battery cell 211 from an external device. For example, the communication circuit may transmit and receive data to and from the external device. In example embodiments, the communication circuit may perform the communication through a communication standard including at least one of various schemes such as a controller area network (CAN), a universal asynchronous receiver-transmitter (UART), Inter-Integrated Circuit (I2C), Serial Peripheral Interface (SPI), a system management bus (SMBus), Ethernet), Bluetooth Low Energy (BLE), Bluetooth, Zigbee, Wi-Fi, and a local interconnect network (LIN). The external device may include at least one of various types of devices such as the battery cell 211, a battery module, a battery pack, a vehicle control system, a charger, and a server.

The processor 120 may control overall operations of the battery management apparatus 100. The processor 120 may process or calculate data. For example, the processor 120 may include at least one of various types of processors such as a central processing unit, a digital signal processor, a microcontroller, and an application processor. The processor 120 may receive the cell voltage of each battery cell 211 from the information acquisition interface 110.

In example embodiments, the battery management apparatus 100 may further include a memory. The memory may store a variety of information. For example, the memory may include at least one of various types of storage devices such as random access memory (RAM), a hard disk drive, a solid state drive (SSD), a portable flash memory, and a memory card. In example embodiment, the memory may store data used in an operation of the processor 120 or data on a result of the operation. In example embodiments, the memory may store a program executed by the processor 120. In example embodiments, the memory may store information on each battery cell 211 included in the slave 210.

The processor 120 may acquire a noise level based on a cell voltage variation in a selected battery cell selected in the slave 210. In example embodiments, the processor 120 may acquire the noise level based on a plurality of cell voltage variations in the selected battery cell.

Here, the selected battery cell may be one of the plurality of battery cells 211 included in the slave 210 and may be a battery cell that is an object of abnormality determination. For example, the processor 120 may select a first battery cell from the plurality of battery cells 211 included in the slave 210 and determine whether the first battery cell is abnormal. In addition, the processor 120 may select a second battery cell from the plurality of battery cells 211 included in the slave 210 and determine whether the second battery cell is abnormal. The processor 120 may select each of the plurality of battery cells 211 included in the slave 210 and determine whether each selected battery cell is abnormal. This may be performed simultaneously or sequentially.

The cell voltage variation may show a degree to which the cell voltage changes in one offset time. An offset time may be a preset time interval. For example, a time interval length of the offset time may be set to 1 second. However, it is merely an example embodiment, and the time interval length of the offset time may vary and set to one of various values such as 0.5 seconds, 2 seconds, and 5 seconds. The noise level may show a degree of noise in the cell voltage. For example, as the noise level is larger, a ratio of the noise is large, and as the noise level is smaller, the ratio of the noise is small.

In example embodiments, the cell voltage variation may be an absolute value of a difference between respective cell voltages at a start time point and an end time point of the offset time. For example, when the offset time is set to 1 second, a start time point of a first offset time may be 1 second, an end time point of the first offset time may be 2 seconds, a start time point of a second offset time may be 2 seconds, and an end time point of the second offset time may be 3 seconds. In this case, a first cell voltage variation in the first offset time may be an absolute value of a difference between a first cell voltage measured at 1 second and a second cell voltage measured at 2 seconds. A second cell voltage variation in the second offset time may be an absolute value of a difference between the second cell voltage measured at 2 second and a third cell voltage measured at 3 seconds. In such a manner, another cell voltage variation may be acquired.

In example embodiments, the processor 120 may acquire the noise level in each unit time based on the cell voltage variation in the selected battery cell in each of at least one offset time included in each unit time. A unit time may have a preset time interval length. For example, when a current period is a t-th unit time, the processor 120 may acquire the noise level in the t-th unit time based on the cell voltage variation in the selected battery cell in each offset time included in the t-th unit time. In example embodiments, the time interval length of the offset time may be smaller than or equal to a time interval length of the unit time. Meanwhile, the unit time may be referred to as a unit time interval.

The processor 120 may acquire a deviation of the selected battery cell based on a cell voltage average value variation in the selected battery cell, a variation average value of the plurality of battery cells 211 included in the slave 210, and the noise level. In example embodiments, the processor 120 may acquire the deviation of the selected battery cell based on the cell voltage average value variation in the selected battery cell in the current period, the variation average value, in each of the current period and a previous period, of the plurality of battery cells 211 included in the slave 210, and the noise level in the current period. For example, when the current period is the t-th unit time, the previous period may be a t-1-th unit time. Here, t may be a natural number greater than or equal to 2.

The cell voltage average value variation in the selected battery cell in the current period may be a difference between respective cell voltage average values of the selected battery cell in the current period and the previous period. For example, The cell voltage average value variation in the selected battery cell in the current period (e.g., the t-th unit time) may be a difference between a cell voltage average value of the selected battery cell in the current period (e.g., the t-th unit time) and a cell voltage average value of the selected battery cell in the previous period (e.g., the t-1-th unit time). A cell voltage average value of the selected battery cell in the t-th unit time may be an average value of cell voltages of the selected battery cell in the t-th unit time.

In example embodiments, among a plurality of unit times, the current period (e.g., the t-th unit time) and the previous period (e.g., the t-1-th unit time) may have an equal length time interval. For example, a time interval length of the unit time may be set to 600 seconds. In this case, a first unit time may be set to 0 to 600 seconds, a second unit time may be set to 600 to 1200 seconds, a third unit time may be set to 1200 to 1800 seconds, and so forth. The first unit time may be a unit time placed first, the second unit time may be a unit time placed second, and the third unit time may be placed third. Meanwhile, 0 to 600 seconds of the first unit time may show a time interval greater than or equal to 0 seconds and less than 600 seconds. An identical scheme may be applied to another time interval. Meanwhile, the time interval length of the unit time may vary and set to one of various values such as 100 seconds, 300 seconds, and 1000 seconds.

The variation average value of the plurality of battery cells 211 included in the slave 210 may be an average value of respective cell voltage average value variations of the plurality of battery cell 211 included in the slave 210. For example, The variation average value in the current period (e.g., the t-th unit time) may be the average value of the respective cell voltage average value variations of the plurality of battery cells 211 in the current period (e.g., the t-th unit time). In addition, The variation average value in the previous period (e.g., the t-1-th unit time) may be the average value of the respective cell voltage average value variations of the plurality of battery cells 211 in the previous period (e.g., the t-1-th unit time).

In example embodiments, The deviation of the selected battery cell in the current period (e.g., the t-th unit time) may be in reverse proportion to the noise level in the current period (e.g., the t-th unit time). As the noise level is larger, the deviation may become smaller, and as the noise level is smaller, the deviation may become larger.

The processor 120 may acquire a final signal of the selected battery cell based on the deviation of the selected battery cell. In example embodiments, the processor 120 may acquire the final signal of the selected battery cell in the current period based on the deviation of the selected battery cell in the current period. Here, the final signal may be an analog signal or a digital signal.

The processor 120 may determine whether the selected battery cell is abnormal based on a result of a first comparison between a level of the final signal and a first threshold value. As an example, when the first comparison result indicates that the level of the final signal is lower than the first threshold value, the processor 120 may determine that the selected battery cell is normal. As another example, when the result of the first comparison indicates that the level of the final signal is greater than or equal to the first threshold value, the processor 120 may determine that the selected battery cell is abnormal (or not normal).

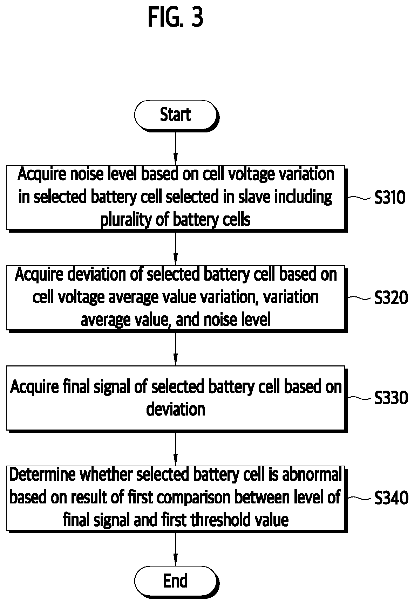

FIG. 3 is a flowchart for describing a battery management method according to example embodiments.

Referring to FIG. 3, the battery management method according to example embodiments may include operation S310 of acquiring a noise level based on a cell voltage variation in a selected battery cell selected in the slave 210, operation S320 of acquiring a deviation of the selected battery cell based on a cell voltage average value variation in the selected battery cell in a current period, a variation average value of a plurality of battery cells, and the noise level, operation S330 of acquiring a final signal of the selected battery cell based on the deviation, and operation S340 of determining whether the selected battery cell is abnormal based on a result of a first comparison between a level of the final signal and a first threshold value. Meanwhile, the battery management method of the present disclosure may be performed by the battery management apparatus 100.

In example embodiments, in the battery management method, the noise level may be acquired based on the cell voltage variation in the selected battery cell selected in the slave 210 which includes the plurality of battery cells 211 in operation S310. Each cell voltage variation may show a degree to which a cell voltage changes within an offset time. In example embodiments, the cell voltage may be acquired by the information acquisition interface 110. In example embodiments, an operation of acquiring the noise level may be performed by the processor 120.

In example embodiments, operation S310 of acquiring the noise level of the selected battery cell may include an operation of acquiring a first calculation value obtained by dividing a sum of squares of cell voltage variations by the number of the cell voltage variations, an operation of acquiring a second calculation value which is a square of a value obtained by dividing a sum of the cell voltage variations by the number of the cell voltage variations, and an operation of acquiring a third calculation value, which is obtained by multiplying a root value of a difference between the first calculation value and the second calculation value by a noise scale, as the noise level. For example, the number of the cell voltage variations may be equal to the number of offset times. The noise scale may be a preset constant.

In example embodiments, in the battery management method, the deviation of the selected battery cell may be acquired based on the cell voltage average value variation in the selected battery cell, the variation average value of the plurality of battery cells, and the noise level in operation S320. In example embodiments, an operation of acquiring the deviation of the selected battery cell may be performed by the processor 120.

The cell voltage average value variation in the selected battery cell in the current period (e.g., a t-th unit time) may be a difference between a cell voltage average value of the selected battery cell in the current period (e.g., the t-th unit time) and a cell voltage average value of the selected battery cell in a previous period (e.g., a t-1-th unit time). The variation average value of the plurality of battery cells included in the slave 210 may be an average value of respective cell voltage average value variations of the plurality of battery cell 211 included in the slave 210.

In example embodiments, operation S320 of acquiring the deviation of the selected battery cell may include an operation of acquiring, as a first calculation value, a difference between the cell voltage average value variation in the selected battery cell in the current period (e.g., the t-th unit time) and the variation average value of the plurality of battery cells in the previous period (e.g., the t-1-th unit time), an operation of acquiring, as a second calculation value, a difference between the cell voltage average value variation of the selected battery cell in the current period (e.g., the t-th unit time) and the variation average value of the plurality of battery cells in the current period (e.g., the t-th unit time), an operation of acquiring a value, which is obtained by dividing a sum value of a first difference value and a second difference value by the variation average value of the plurality of battery cells in the current period (e.g., the t-th unit time), as a third calculation value, and an operation of acquiring a fourth calculation value, which is obtained by dividing the third calculation value by the noise level, as the deviation.

In example embodiments, in the battery management method, the final signal of the selected battery cell may be acquired based on the deviation of the selected battery cell in operation S330. In example embodiments, an operation of acquiring the final signal of the selected battery cell may be performed by the processor 120.

In example embodiments, operation S330 of acquiring the final signal may include an operation of acquiring a slope of the deviation, which is a difference between a deviation variation of the deviation and a deviation average value variation, and an operation of acquiring the final signal which corresponds to the deviation and the slope.

In example embodiments, operation S330 of acquiring the final signal may further include an operation of acquiring a value, which is obtained by dividing the deviation by a noise reduction level, as a noise reduction value. In example embodiments, in the operation of the final signal which corresponds to the deviation and the slope, a value obtained by multiplying the deviation, the slope, and the noise reduction value may be acquired as the final signal.

In example embodiments, the deviation variation may be a value obtained by multiplying a difference between deviations of the selected battery cell in the current period (e.g., the t-th unit time) and the previous period (e.g., the t-1-th unit time) by a slope scale. In example embodiments, the deviation average value variation may be a value obtained by multiplying a difference between average values of deviations of the plurality of battery cells in the current period (e.g., the t-th unit time) and the previous period (e.g., the t-1-th unit time) by the slope scale.

In example embodiments, in the battery management method, whether the selected battery cell is abnormal may be determined based on the result of the first comparison between the level of the final signal and the first threshold value in operation S340. In example embodiments, an operation of determining whether the selected battery cell is abnormal may be performed by the processor 120.

In example embodiments, operation S340 of determining whether the selected battery cell is abnormal may include an operation of acquiring a result of a second comparison by comparing a deviation ratio, which is based on a first maximum value and a minimum value of the deviation, and a second threshold value and an operation of determining whether the selected battery cell is abnormal depending on the result of the first comparison and the result of the second comparison.

In example embodiments, the operation of acquiring the result of the second comparison may include an operation of acquiring a first ratio of a second maximum value of the deviation, excluding the first maximum value, to the first maximum value, an operation of acquiring a second ratio of one of the first maximum value and the second maximum value to the minimum value, and an operation of acquiring a difference between the first ratio and the second ratio as the deviation ratio.

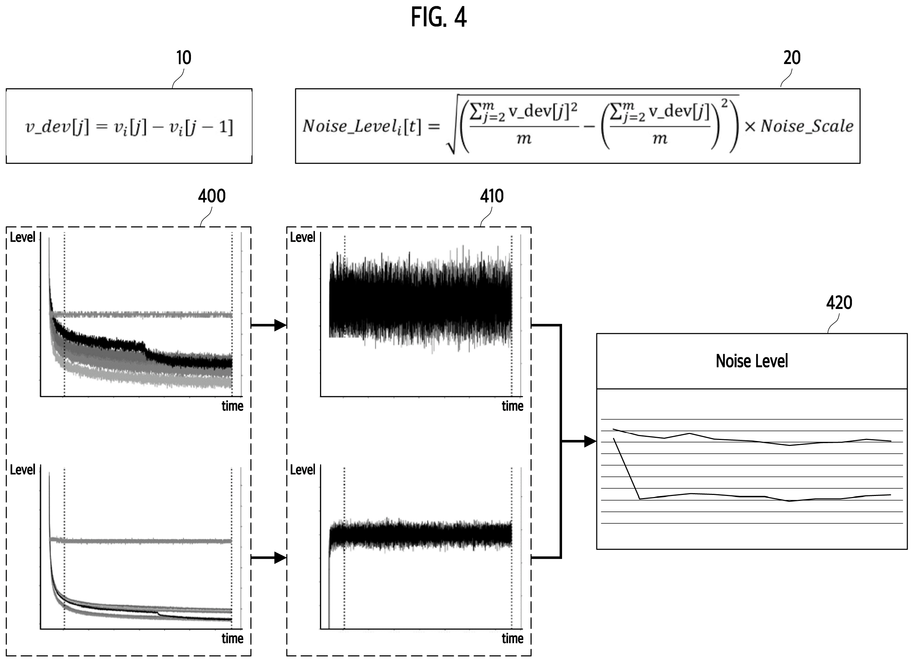

FIG. 4 is a diagram for describing a noise level according to example embodiments.

Referring to FIG. 4, in example embodiments, in a battery management method, the noise level in a t-th unit time may be acquired by using a cell voltage variation in a selected battery cell in each of a plurality of offset times included in the t-th unit time. Hereinafter, it is supposed that the selected battery cell is an i-th battery cell selected in the slave 210 which includes the plurality of battery cells 211. i is a natural number greater than or equal to 1. In other words, in the battery management method, the noise level in the t-th unit time may be acquired by using a respective plurality of cell voltage variations in the selected battery cell in the plurality of offset times. In example embodiments, in the battery management method, the noise level may be acquired by using a standard deviation of the cell voltage variation in each of the offset times.

In example embodiments, the cell voltage variation in the selected battery cell may be acquired through the following Equation 1 represented by reference numeral 10. The selected battery cell may be the i-th battery cell among the plurality of battery cells 211 included in the slave 210. i is a natural number greater than or equal to 1. [Equation 1] $v _ dev \left[j\right] = {v}_{i} \left[j\right] - {v}_{i} \left[j-1\right]$

Here, v_dev[j] is the cell voltage variation in the i-th battery cell in offset time j. vi[j] is a cell voltage of the i-th battery cell in offset time j. vi[j-1] is the cell voltage of the i-th battery cell in offset time j-1. j may denote a place, in an order, of an offset time included an identical unit time (e.g., the t-th unit time) or a number of the offset time. j is a natural number greater than or equal to 2.

In example embodiments, the battery management method may include an operation of acquiring a first calculation value obtained by dividing a sum of squares of the cell voltage variations in the selected battery cell by the number of the cell voltage variations, an operation of acquiring a second calculation value which is a square of a value obtained by dividing a sum of the cell voltage variations by the number of the cell voltage variations, and an operation of acquiring a third calculation value, which is obtained by multiplying a root value of a difference between the first calculation value and the second calculation value by a noise scale, as the noise level.

For example, the noise level of the selected battery cell in the t-th unit time may be acquired through the following Equation 2 represented by reference numeral 20. The selected battery cell may be the i-th battery cell among the plurality of battery cells 211 included in the slave 210. i is a natural number greater than or equal to 1. [Equation 2] $Noise _ {Level}_{i} \left[t\right] = \sqrt{\left(\frac{{\sum }_{j = 2}^{m} v _ dev {\left[j\right]}^{2}}{m}-{\left(\frac{{\sum }_{j = 2}^{m} v _ dev \left[j\right]}{m}\right)}^{2}\right)} \times Noise _ Scale$

Noise_Levelᵢ[t] is the noise level of the i-th battery cell in the t-th unit time. $\frac{{\sum }_{j = 2}^{m} v _ dev {\left[j\right]}^{2}}{m}$ is the first calculation value obtained by dividing the sum of squares of the cell voltage variations by the number of the cell voltage variations. ${{\sum }_{j = 2}^{m} v _ dev \left[j\right]}^{2}$ is the sum of squares of the cell voltage variations in the i-th battery cell. m is a natural number greater than or equal to 2. m denotes the number of the cell voltage variations, and m+1 denotes the number of cell voltages. v_dev[j] is the cell voltage variation in the i-th battery cell in offset time j. ${\sum }_{j = 2}^{m} v _ dev \left[j\right]$ is the sum of the cell voltage variations. ${\left(\frac{{\sum }_{j = 2}^{m} v _ dev \left[j\right]}{m}\right)}^{2}$ is the second calculation value which is a square of a value obtained by dividing the sum of the cell voltage variations by the number of the cell voltage variations. $\sqrt{\left(\frac{{\sum }_{j = 2}^{m} v _ dev {\left[j\right]}^{2}}{m}-{\left(\frac{{\sum }_{j = 2}^{m} v _ dev \left[j\right]}{m}\right)}^{2}\right)}$ is the root value of the difference between the first calculation value and the second calculation value. Noise_Scale is the noise scale and a preset constant value. For example, the noise scale may be a value ranging from 1 to 5. However, it is merely an example embodiment, and the noise scale may be modified into and carried out as various values.

According to example embodiments, a voltage measured in a battery cell included in each of first and second slaves in different environments may be shown as a first waveform 400. For example, when converted into a voltage variation through Equation 1 represented by reference numeral 10, the first waveform 400 of the voltage may be shown as a second waveform 410. When converted into the noise level through Equation 2 represented by reference numeral 20, the second waveform 420 of the voltage variation may be shown as a third waveform 420. For example, an upper portion of the first waveform 400 may show an inflection in voltage larger than that of a lower portion. In this case, an upper portion of the second waveform 410 may show an inflection in voltage variation larger than that of a lower portion, and a larger noise level may be shown in the third waveform 420. For example, as the noise level is larger, an area of the inflection in voltage or voltage variation may be shown to be large.

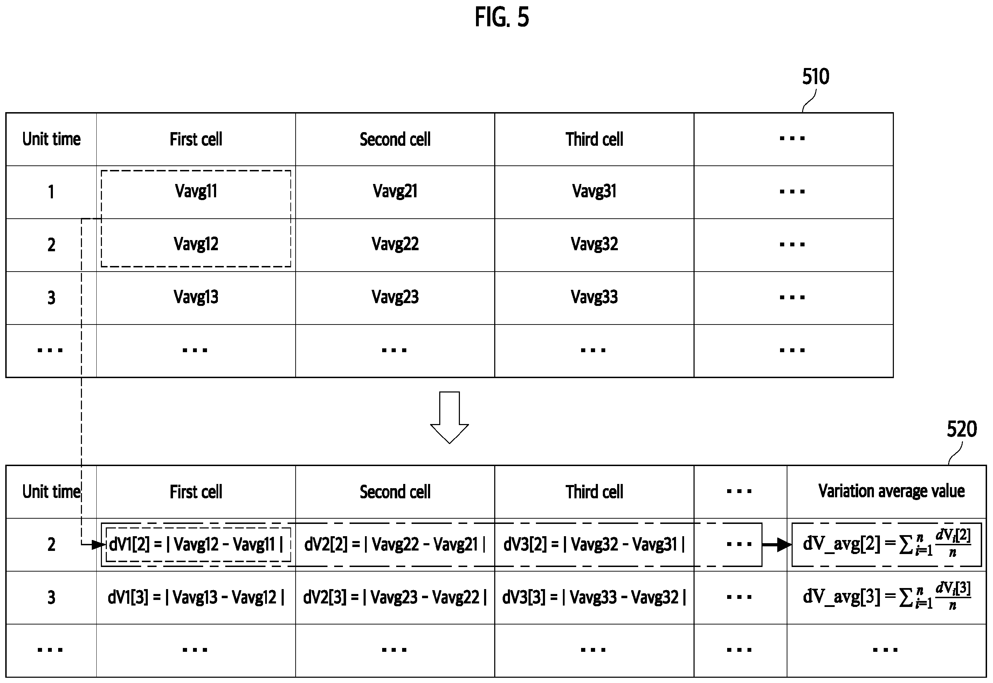

FIG. 5 is a diagram for describing a cell voltage average value, a cell voltage average value variation, and a variation average value according to example embodiments.

Referring to FIG. 5, in a battery management method according to example embodiments, a cell voltage of each of the plurality of battery cells 211 included in one slave 210 may be measured. Here, a battery cell may be simply referred to as a cell. For example, a plurality of cells may include first to third cells.

In the battery management method, the cell voltage average value of each cell in each of a plurality of unit times may be acquired. For example, a time interval length of a unit time may be 600 seconds, but may be modified into and carried out as various values.

For example, as shown in a first table 510, a first-first cell voltage average value Vavg11 may be an average value of cell voltages of a first cell, which are measured in a first unit time. A first-second cell voltage average value Vavg12 may be an average value of cell voltages of the first cell, which are measured in a second unit time. The first unit time, the second unit time, a third unit time, and the like may be successively associated times. For example, an end time point of the first unit time may be equal to a start time point of the second unit time, and an end time point of the second unit time may be equal to a start time point of the third time point.

In the battery management method, the cell voltage average value variation in each cell in each unit time may be acquired. For example, in the battery management method, the cell voltage average value variation in the first cell in a current period (e.g., a t-th unit time) may be acquired. The cell voltage average value variation in the first cell in the current period (e.g., the t-th unit time) may be an absolute value of a difference between respective cell voltage average values of the first cell in the current period (e.g., the t-th unit time) and a previous period (e.g., a t-1-th unit time).

For example, when the current period is the second unit time, a cell voltage average value variation dV1[2] in the first cell in the current period (e.g., the second unit time) may be an absolute value of a difference between the first-second cell voltage average value Vavg12 of the first cell in the current period (e.g., the second unit time) and the first-first cell voltage average value Vavg11 of the first cell in the previous unit time (e.g., the first unit time). In such a manner, the cell voltage average value variation in by cell in each unit time may be acquired.

In the battery management method, the variation average value in each unit time may be acquired. The variation average value in each unit time may be an average value of respective cell voltage average value variations in the plurality of cells which is included in the one slave 210 in each unit time. For example, as shown in a second table 520, a variation average value dV_avg[2] in the second unit time may be an average value of respective cell voltage average value variations dV1[2], dV2[2], dV3[2], and the like in the cells in the second unit time. That is, the variation average value dV_avg[2] in the second unit time may be a value obtained by dividing a sum value of the respective cell voltage average value variations dV1[2], dV2[2], dV3[2], and the like in the cells included in the one slave 210 in the second unit time by n that is the number of the cells included in the one slave 210.

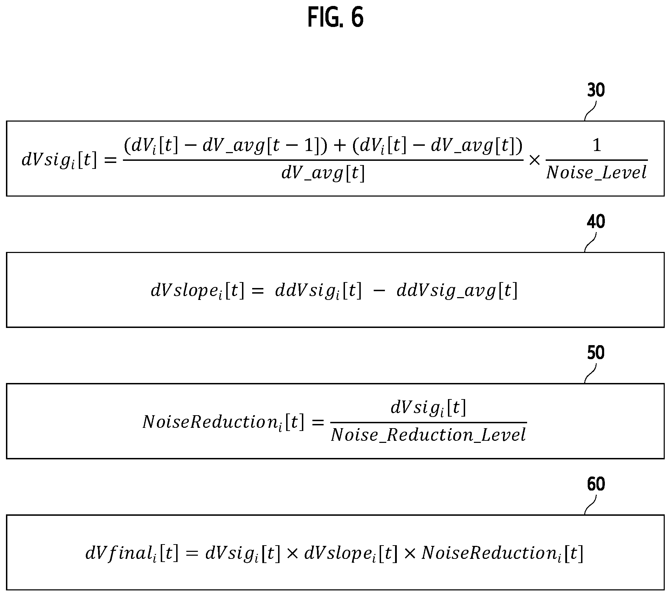

FIG. 6 is a diagram for describing a deviation, a slope, a noise reduction value, and a final signal according to example embodiments.

Referring to FIG. 6, in a battery management method according to example embodiments, the deviation of a selected battery cell may be acquired based on a cell voltage average value variation in the selected battery cell, a variation average value of a plurality of battery cells, and a noise level. The above description with reference to FIG. 4 may be identically applied to the noise level. The above description with reference to FIG. 5 may be identically applied to the cell voltage average value variation and the variation average value.

In example embodiments, the battery management method may include an operation of acquiring, as a first calculation value, a difference between the cell voltage average value variation in the selected battery cell in a current period (e.g., a t-th unit time) and the variation average value of the plurality of battery cells in a previous period (e.g., a t-1-th unit time), an operation of acquiring, as a second calculation value, a difference between the cell voltage average value variation of the selected battery cell in the current period (e.g., the t-th unit time) and the variation average value of the plurality of battery cells in the current period (e.g., the t-th unit time), an operation of acquiring a value, which is obtained by dividing a sum value of a first difference value and a second difference value by the variation average value of the plurality of battery cells in the current period (e.g., the t-th unit time), as a third calculation value, and an operation of acquiring a fourth calculation value, which is obtained by dividing the third calculation value by the noise level, as the deviation.

In example embodiments, the deviation of the selected battery cell in the current period may be acquired through the following Equation 3 represented by reference numeral 30. For example, the selected battery cell may be an i-th battery cell among the plurality of battery cells 211 included in the slave 210, and the current period may be the t-th unit time, and the previous period may be the t-1-th unit time. [Equation 3] ${dVsig}_{i} \left[t\right] = \frac{\left({dV}_{i}\left[t\right]-dV_avg\left[t-1\right]\right) + \left({dV}_{i}\left[t\right]-dV_avg\left[t\right]\right)}{dV _ avg \left[t\right]} \times \frac{1}{Noise _ Level}$

Here, dVsigᵢ[t] is the deviation (or a deviation signal) of the i-th battery cell in the t-th unit time. dVᵢ[t] is the cell voltage average value variation in the i-th battery cell in the t-th unit time. dV_avg[t-1] is the variation average value of the plurality of battery cells 211 included in the slave 210 in the t-1-th unit time. dV_avg[t] is the variation average value of the plurality of battery cells 211 included in the slave 210 in the t-th unit time. Noise_Level is the noise level of the i-th battery cell in the t-th unit time.

Here, (dVᵢ[t]-dV_avg[t-1]) is the first calculation value, (dVᵢ[t]-dV_avg[t]) is the second calculation value, $\frac{\left({dV}_{i}\left[t\right]-dV_avg\left[t-1\right]\right) + \left({dV}_{i}\left[t\right]-dV_avg\left[t\right]\right)}{dV _ avg \left[t\right]}$ is the third calculation value, and $\frac{\left({dV}_{i}\left[t\right]-dV_avg\left[t-1\right]\right) + \left({dV}_{i}\left[t\right]-dV_avg\left[t\right]\right)}{dV _ avg \left[t\right]} \times \frac{1}{Noise _ Level}$ is the fourth calculation value.

In example embodiments, in the battery management method, the slope of the deviation, which is a difference between a deviation variation of the deviation and a deviation average value variation, may be acquired. In addition, an operation of acquiring the final signal which corresponds to the deviation and the slope may be included.

In example embodiments, the slope of the deviation in the current period may be acquired through the following Equation 4 represented by reference numeral 40. For example, the selected battery cell may be the i-th battery cell among the plurality of battery cells 211 included in the slave 210, and the current period may be the t-th unit time. [Equation 4] ${dVslope}_{i} \left[t\right] = {ddVsig}_{i} \left[t\right] - ddVsig _ avg \left[t\right]$

Here, dVslopeᵢ[t] is the slope of the deviation of the i-th battery cell in the t-th unit time. ddVsigᵢ[t] is the deviation variation of the deviation of the i-th battery cell in the t-th unit time. ddVsig_avg[t] is the deviation average value variation in the plurality of battery cells 211 included in the slave 210 in the t-th unit time.

In example embodiments, in the battery management method, a value obtained by dividing the deviation by a noise reduction level may be acquired as the noise reduction value. In example embodiments, the noise reduction value may be acquired through the following Equation 5 represented by reference numeral 50. For example, the selected battery cell may be the i-th battery cell among the plurality of battery cells 211 included in the slave 210, and the current period may be the t-th unit time. [Equation 5] ${NoiseReduction}_{i} \left[t\right] = \frac{{dVsig}_{i} \left[t\right]}{Noise _ Reduction _ Level}$

Here, NoiseReduction;[t] is the noise reduction value of the i-th battery cell in the t-th unit time. dVsigᵢ[t] is the deviation of the i-th battery cell in the t-th unit time. Noise_Reduction_Level may be the noise reduction level and may be a preset constant value.

In example embodiments, the final signal may correspond to the deviation and the slope. As an example, in the battery management method, a value obtained by multiplying the deviation by the slope may be acquired as the final signal. As another example, in the battery management method, a value obtained by multiplying the deviation, the slope, and the noise reduction value together may be acquired as the final signal.

In example embodiments, the final signal may be acquired through the following Equation 6 represented by reference numeral 60. [Equation 6] ${dVfinal}_{i} \left[t\right] = {dVsig}_{i} \left[t\right] \times {dVslope}_{i} \left[t\right] \times {NoiseReduction}_{i} \left[t\right]$

Here, dVfinalᵢ[t] is the final signal of the i-th battery cell in the t-th unit time. In other words, the final signal may be acquired at each unit time and for each battery cell. dVsigᵢ[t] is the deviation of the i-th battery cell in the t-th unit time. dVslopeᵢ[t] is the slope of the deviation of the i-th battery cell in the t-th unit time. NoiseReduction;[t] is the noise reduction value of the i-th battery cell in the t-th unit time.

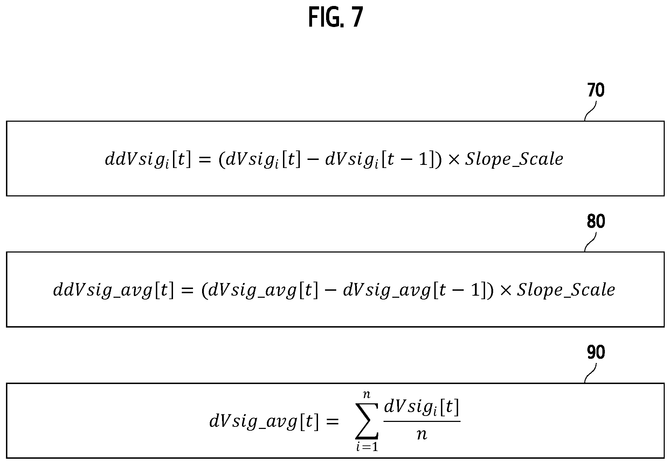

FIG. 7 is a diagram for describing a method of acquiring a noise reduction value according to example embodiments.

Referring to FIG. 7, in a battery management method according to example embodiments, a slope of a deviation, which is a difference between a deviation variation of the deviation and a deviation average value variation, may be acquired.

In example embodiments, the deviation variation of the deviation may be a value obtained by multiplying a difference between deviations of a selected battery cell in a current period (e.g., a t-th unit time) and a previous period (e.g., a t-1-th unit time) by a slope scale. For example, the deviation variation may be acquired through the following Equation 7 represented by reference numeral 70. [Equation 7] ${ddVsig}_{i} \left[t\right] = \left({dVsig}_{i}\left[t\right]-{dVsig}_{i}\left[t-1\right]\right) \times Slope _ Scale$

ddVsigᵢ[t] is the deviation variation of the deviation of an i-th battery cell in the t-th unit time. dVsigᵢ[t] is the deviation of the i-th battery cell in the t-th unit time. dVsigᵢ[t-1] is the deviation of the i-th battery cell in the t-1-th unit time. Slope_Scale is the slope scale and may be a preset constant value.

In example embodiments, the deviation average value variation may be a value obtained by multiplying a difference between average values of deviations of a plurality of battery cells in the current period (e.g., the t-th unit time) and the previous period (e.g., the t-1-th unit time) by the slope scale. For example, the deviation average value variation may be acquired through Equation 8 represented by reference numeral 80. [Equation 8] $ddVsig _ avg \left[t\right] = \left(dVsig_avg\left[t\right]-dVsig_avg\left[t-1\right]\right) \times Slope _ Scale$

ddVsig_avg[t] is the deviation average value variation in the plurality of battery cells 211 included in the slave 210 in the t-th unit time. dVsig_avg[t] is an average value of deviations of the plurality of battery cells 211 included in the slave 210 in the t-th unit time. dVsig_avg[t-1] is an average value of deviations of the plurality of battery cells 211 included in the slave 210 in the t-1-th unit time. Slope_Scale is the slope scale and may be a preset constant value.

In example embodiments, the average value of the deviations of the plurality of battery cells 211 included in the slave 210 in the t-th unit time may be acquired through Equation 9 represented by reference numeral 90. [Equation 9] $dVsig _ avg \left[t\right] = {\sum }_{i = 1}^{n} \frac{{dVsig}_{i} \left[t\right]}{n}$

Here, dVsig_avg[t] is the average value of the deviations of the plurality of battery cells 211 included in the slave 210 in the t-th unit time. dVsigᵢ[t] is the deviation of the i-th battery cell in the t-th unit time. n denotes the number of the plurality of battery cells 211 included in the slave 210.

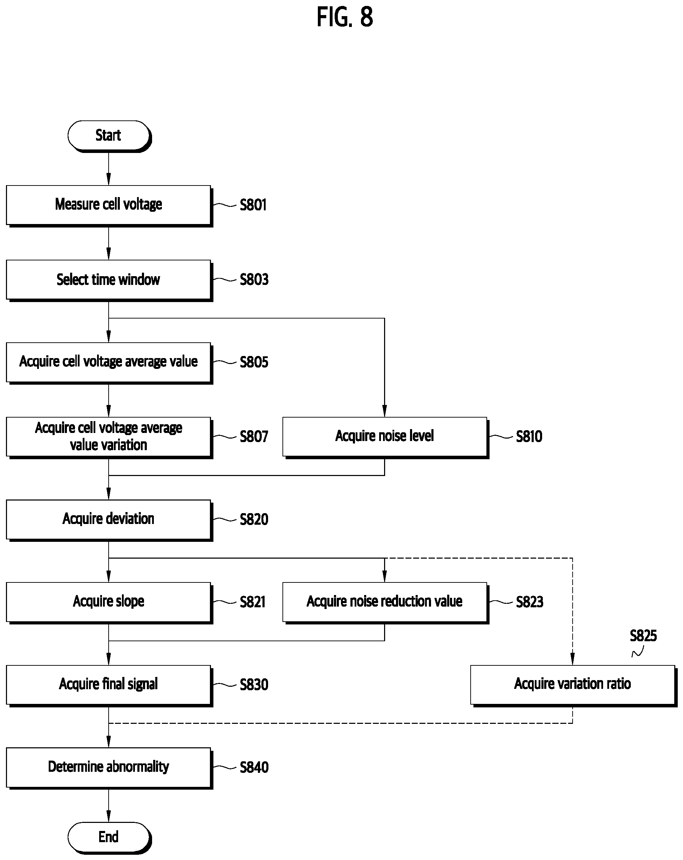

FIG. 8 is a diagram for describing a battery management method according to example embodiments.

Referring to FIG. 8, in a battery management method according to example embodiments, a cell voltage of each of the plurality of battery cells 211 included in the slave 210 may be measured periodically. For example, the cell voltage may be measured at intervals of an offset time.

In the battery management method, a time window may be selected in operation S803. The time window may have a preset time interval length. For example, a time interval length of the time window may be 7200 seconds. However, this is merely an example embodiment, and the time interval length of the time window may be modified into and carried out as various values. For example, in the battery management method, a T-th time window may be selected. Here, T may be a natural number greater than or equal to 1.

In the battery management method, a cell voltage average value of each of the plurality of battery cells 211 in each of a plurality of unit times included in the time window which is selected based on the cell voltage of each of the plurality of battery cells 211 may be acquired in operation S805. For example, in the battery management method, the cell voltage average value of a selected battery cell in each of a t-th unit time and a t-1-th unit time may be acquired. Here, t may be a natural number greater than or equal to 2. A unit time may have a preset time interval length. For example, a time interval length of the unit time may be 600 seconds. However, it is merely an example embodiment, and the time interval length of the unit time may be modified into and carried out as various values.

In the battery management method, a cell voltage average value variation in each battery cell in each unit time may be acquired in operation S807. For example, in the battery management method, the cell voltage average value variation in the selected battery cell in the t-th unit time may be acquired.

In the battery management method, a noise level may be acquired based on the cell voltage of each battery cell in each of a plurality of offset times included in each unit time in operation S810. Here, the unit time may be included in the selected time window. For example, in the battery management method, the noise level in the t-th unit time may be acquired by using a cell voltage variation in the selected battery cell in each of a plurality of offset times included in the t-th unit time. An offset time may have a preset time interval length. For example, a time interval length of the offset time may be 1 second. However, it is merely an example embodiment, and the time interval length of the offset time may be modified into and carried out as various values.

In the battery management method, a deviation of each battery cell may be acquired based on a cell voltage average value variation in each battery cell included in the slave 210, a variation average value of the plurality of battery cells 211 included in the slave 210, and the noise level of each battery cell in operation S820. For example, the deviation of the selected battery cell may be acquired based on the cell voltage average value variation in the selected battery cell, the variation average value of the plurality of battery cells 211 included in the slave 210, and the noise level of the selected battery cell.

In the battery management method, a slope of the deviation of each battery cell may be acquired based on the deviation of each battery cell in operation S821. In example embodiments, in the battery management method, the slope of the deviation, which is a difference between a deviation variation of the deviation of the selected battery cell and a deviation average value variation in the plurality of battery cells, may be acquired.

In the battery management method, a noise reduction value of each battery cell may be acquired based on the deviation of each battery cell in operation S823. In example embodiments, in the battery management method, a value obtained by dividing the deviation of the selected battery cell by a noise reduction level may be acquired as the noise reduction value.

In the battery management method, a final signal of each battery cell may be acquired based on at least one of the deviation of each battery cell, the slope, and the noise reduction value in operation S830. For example, in the battery management method, a value obtained by multiplying the deviation of the selected battery cell, the slope, and the noise reduction value together may be acquired as the final signal.

In example embodiments, in the battery management method, whether each battery cell is abnormal may be determined based on a result of a first comparison between a level of the final signal of each battery cell and a first threshold value in operation S840. For example, when the level of the final signal of the selected battery cell is larger than the first threshold value, the selected battery cell may be determined to be abnormal.

In example embodiments, the battery management method may include operation S825 of acquiring a deviation ratio in each battery cell based on the deviation of each battery cell. The deviation ratio may be acquired based on a first maximum value and a minimum value of the deviation of the selected battery cell.

The battery management method may include an operation of acquiring a result of a second comparison by comparing the deviation ratio and a second threshold value. In example embodiments, the operation of acquiring the result of the second comparison may include an operation of acquiring a first ratio of a second maximum value of the deviation, excluding the first maximum value, to the first maximum value, an operation of acquiring a second ratio of one of the first maximum value and the second maximum value to the minimum value, and an operation of acquiring a difference between the first ratio and the second ratio as the deviation ratio.

The battery management method may include an operation of determining whether the selected battery cell is abnormal depending on the result of the first comparison and the result of the second comparison. For example, when the result of the first comparison indicates that the level of the final signal of the selected battery cell is larger than the first threshold value, and when the result of the second comparison indicates that the deviation ratio in the selected battery cell is larger than the second threshold value, the selected battery cell may be determined to be abnormal. For example, when the result of the first comparison indicates that the level of the final signal of the selected battery cell is smaller than the first threshold value, and when the result of the second comparison indicates that the deviation ratio in the selected battery cell is smaller than the second threshold value, the selected battery cell may be determined to be normal.

An electronic apparatus according to the above-described example embodiments may include a processor, a memory that stores and executes program data, a permanent storage such as a disk drive, a communication port for communicating with an external device, and a user interface device such as a touch panel, a key, and a button.

Methods implemented by software or algorithms in the present disclosure may be implemented as a program and stored in a computer-readable recording medium (or storage medium). The program may include computer-readable code or program instructions for executing a plurality of steps. In an example embodiment, the recording medium may be implemented as a device such as a server, a hard disk drive (HDD), a solid state drive (SSD), a read-only memory (ROM), a random access memory (RAM), a CD (compact disc)-ROM, magnetic tape, a floppy disk, or an optical data storage. In an example embodiment, a quick-response (QR) code or a document also may correspond to the recording medium when a camera of a machine such as a computer identifies the QR code or the document. As such, as far as the computer may read and execute the recording medium, a type of the recording medium is not limited. In an example embodiment, the program may be stored in one recording medium or may be dispersed and stored in various recording media in computer systems connected by a network so that portions of the program are executed in a dispersed manner.

In example embodiments, the computer-readable recording medium may be provided in the form of a non-transitory recording medium. Here, the term "non-transitory" means that the recording medium is a tangible device and not a transitory signal (e.g., an electromagnetic wave). The term is not for distinguishing a case of storing data recorded in the recording medium semi-permanently from a case of the storing thereof temporarily. Meanwhile, this is merely an example embodiment, and the recording medium may be modified into and carried out as a transitory one.

A Method according to an example embodiment may be included in a computer program product to be provided. The computer program product may be distributed in the form of a computer-readable medium (e.g., a CD-ROM), may be distributed on-line (for example, may be uploaded or downloaded) through an application store, or may be directly distributed between two or more terminal devices. The method according to an example embodiment may be implemented as a computer program itself.

The present example embodiments may be represented by functional blocks and various processing steps. These functional blocks may be implemented by various numbers of hardware and/or software configurations that execute specific functions. For example, the present example embodiments may adopt integrated circuit configurations such as a memory, a processor, a logic circuit, and a look-up table that may execute various functions by control of one or more microprocessors or other control devices. Similarly to that elements may be executed by software programming or software elements, the present example embodiments may be implemented by programming or scripting languages such as C, C++, Java, and assembler language, including various algorithms implemented by combinations of data structures, processes, routines, or of other programming configurations. Functional aspects may be implemented by algorithms executed by one or more processors. In addition, the present example embodiments may adopt the related art for electronic environment setting, signal processing, and/or data processing, for example. The terms "mechanism", "element", "means", and "configuration" may be widely used and are not limited to mechanical and physical components. These terms may include the meaning of a series of routines of software in association with a processor.

The above-described embodiments are merely examples and other embodiments may be implemented within the scope of the following claims.

## Claims

1. A battery management method comprising:
acquiring a noise level based on cell voltage variations in a selected battery cell selected in a slave including a plurality of battery cells;
acquiring a deviation of the selected battery cell based on a cell voltage average value variation that is a difference between respective cell voltage average values of the selected battery cell in a current period and a previous period, a variation average value that is an average value of cell voltage average value variations of the plurality of battery cells, and the noise level;
acquiring a final signal of the selected battery cell based on the deviation; and
determining whether the selected battery cell is abnormal based on a first comparison result between a level of the final signal and a first threshold value.

2. The battery management method of claim 1, wherein the acquiring of the final signal comprises:
acquiring a slope of the deviation, which is a difference between a deviation variation of the deviation and a deviation average value variation; and
acquiring the final signal which corresponds to the deviation and the slope.

3. The battery management method of claim 2, wherein the acquiring of the final signal further comprises acquiring a value, which is obtained by dividing the deviation by a noise reduction level, as a noise reduction value, and
wherein the acquiring of the final signal which corresponds to the deviation and the slope, comprises acquiring a value obtained by multiplying the deviation, the slope, and the noise reduction value together as the final signal.

4. The battery management method of claim 2, wherein the deviation variation is a value obtained by multiplying a difference between deviations of the selected battery cell in the current period and the previous period by a slope scale.

5. The battery management method of claim 4, wherein the deviation average value variation is a value obtained by multiplying a difference between average values of deviations of the plurality of battery cells in the current period and the previous period by a slope scale.

6. The battery management method of claim 1, wherein the determining of whether the selected battery cell is abnormal comprises:
acquiring a second comparison result by comparing a deviation ratio, which is based on a first maximum value and a minimum value of the deviation, and a second threshold value; and
determining whether the selected battery cell is abnormal depending on the first comparison result and the second comparison result.

7. The battery management method of claim 6, wherein the acquiring of the second comparison result comprises:
acquiring a first ratio of a second maximum value of the deviation, excluding the first maximum value, to the first maximum value;
acquiring a second ratio of one of the first maximum value and the second maximum value to the minimum value; and
acquiring a difference between the first ratio and the second ratio as the deviation ratio.

8. The battery management method of claim 1, wherein the acquiring of the noise level comprises:
acquiring a first calculation value obtained by dividing a sum of squares of the cell voltage variations by a number of the cell voltage variations;
acquiring a second calculation value which is a square of a value obtained by dividing a sum of the cell voltage variations by the number of the cell voltage variations; and
acquiring a third calculation value, which is obtained by multiplying a root value of a difference between the first calculation value and the second calculation value by a noise scale, as the noise level.

9. The battery management method of claim 1, wherein the acquiring of the deviation comprises:
acquiring, as a first calculation value, a difference between the cell voltage average value variation in the selected battery cell in the current period and the variation average value of the plurality of battery cells in the previous period;
acquiring, as a second calculation value, a difference between the cell voltage average value variation in the selected battery cell in the current period and the variation average value of the plurality of battery cells in the current period;
acquiring a value, which is obtained by dividing a sum value of the first difference value and the second difference value by the variation average value of the plurality of battery cells in the current period, as a third calculation value; and
acquiring a fourth calculation value, which is obtained by dividing the third calculation value by the noise level, as the deviation.

10. A battery management apparatus comprising:
an information acquisition interface configured to acquire a cell voltage of each of a plurality of battery cell included in a slave; and
a processor,
wherein the processor is configured to:
acquire a noise level based on cell voltage variations in a selected battery cell selected in the slave;
acquire a deviation of the selected battery cell based on a cell voltage average value variation that is a difference between respective cell voltage average values of the selected battery cell in a current period and a previous period, a variation average value that is an average value of cell voltage average value variations of the plurality of battery cells, and the noise level;
acquire a final signal of the selected battery cell based on the deviation; and
determine whether the selected battery cell is abnormal based on a first comparison result between a level of the final signal and a first threshold value.

11. A computer-readable recording medium in which a program for executing the battery management method of claim 1 on a computer is recorded.
